# EUROPEAN PATENT APPLICATION

(11) **EP 4 801 222 A1**
(43) Date of publication of application: **02.09.2026**
(21) Application number: 25226448.6
(22) Date of filing: 22.12.2025
(51) Int. Cl.: H10D 30/01, H10D 30/00, H10D 64/23, H10D 64/27, H10D 84/83

(54) **BACKSIDE CONTACTS USED TO FORM A GATE TIE-DOWN**

(30) Priority: 28.02.2025 US 202519067064
(71) Applicant: INTEL Corporation, Santa Clara, CA 95054 (US)
(72) Inventor: MANNEBACH, Ehren, Beaverton, 97007 (US); MILLS, Shaun, Hillsboro, 97124 (US); D'SILVA, Joseph, Hillsboro, 97124 (US); KOBRINSKY, Mauro J., Portland, 97229 (US); EL HAJJAM, Gabriel Khalil, Vancouver, 98663 (US); NABORS, Marni, Portland, 97229 (US)
(74) Representative: HGF

(57) **Abstract**

Techniques are provided herein to form an integrated circuit having backside conductive contacts (238/240) as part of a gate tie-down structure. Backside cavities beneath a gate structure and an adjacent source region (106b) may be formed using backside lithography and anisotropic etching. The backside cavities are subsequently filled with a conductive material to form the backside contacts. A semiconductor device includes a gate structure around (108) or otherwise on a semiconductor region (104) that extends from a first source region to a second source or drain region. The substrate beneath the semiconductor device is removed and replaced with a backside dielectric material (130). Lithographic operations may be performed on the backside dielectric material along with one or more anisotropic etches to form a first cavity beneath the gate structure and a second cavity beneath the first source region. The backside conductive contacts are then formed within the backside cavities.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Due to the small size of the transistor elements, such as the transistor gate, source, or drain, it can be difficult to provide effective contacts while maintaining desired operation speeds and power requirements. Accordingly, there remain a number of non-trivial challenges with respect to forming such high-density semiconductor devices.

### BRIEF DESCRIPTION OF THE DRAWINGS

Figures 1A and 1B are cross-sectional views of different semiconductor devices in an integrated circuit that include at least one gate tie-down device using backside contacts, in accordance with some embodiments of the present disclosure.
Figures 2A - 2O are cross-sectional views that illustrate different stages in an example process for forming an integrated circuit having a backside-coupled gate tie-down structure, in accordance with some embodiments of the present disclosure.
Figure 3 illustrates a cross-sectional view of a chip package containing one or more semiconductor dies, in accordance with some embodiments of the present disclosure.
Figure 4 is a flowchart of a fabrication process for semiconductor devices having at least one backside-coupled gate tie-down structure, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having one or more gate tie-down structures that are formed using backside contacts. According to some embodiments, backside cavities beneath both the gate structure and its adjacent source region are formed using backside lithography and anisotropic etching. The backside cavities are then subsequently filled with a conductive material to form the backside contacts on the underside of both the gate and the adjacent source region. The techniques can be used in any number of integrated circuit applications and are particularly useful with respect to logic and memory cells, such as those cells that use finFETs, gate-all-around transistors (e.g., ribbonFETs and nanowire FETs), or forksheet transistors. In an example, a semiconductor device includes a gate structure around or otherwise on a semiconductor region. The semiconductor region can be, for example, a fin of semiconductor material that extends from a source region to a drain region, or one or more nanowires, nanoribbon, or nanosheets of semiconductor material that extend from a source region to a drain region. The substrate beneath the semiconductor device may be removed from the backside to expose a subfin region beneath the semiconductor region. The subfin region may be removed using a backside etch and replaced with a dielectric material. Lithographic operations may be performed on any backside dielectric materials along with an anisotropic etch through the backside dielectric materials to form a first cavity that exposes a bottom surface of a given gate structure and a second cavity that exposes a bottom surface of an adjacent source region. One or more conductive materials may be formed within the first and second cavities to create the backside contacts. A backside conductive layer may be used to short the backside contacts together, which effectively shuts the transistor off and causes it to act as an electrically isolating structure. Numerous variations and embodiments will be apparent in light of this disclosure.

### General Overview

As previously noted above, there remain a number of non-trivial challenges with respect to integrated circuit fabrication. For example, isolating semiconductor devices from one another is important to provide desired circuit and logic arrangements. Several different isolation structures and techniques are used to provide electrical isolation. One such structure is a fin isolation structure that electrically isolates different portions of a semiconductor fin. Since several devices can be formed along the length of a single fin, fin isolation structures can be used to isolate devices along the fin. The fin isolation structures typically include dielectric material formed within a trench that cuts through a given fin and runs perpendicular to the length of the fin. However, the etching process used to form trenches that are later filled with dielectric material can suffer from significant variation across a given die, which can require over etching in certain areas to ensure that the isolation structures extend through the entire height of the devices. The over etching can damage other semiconductor features, such as spacer structures, which leads to decreased device performance or inoperability.

One other type of isolation structure is a gate tie-down, which includes a transistor with the gate electrically shorted to the source region. This forms a dummy gate structure that is permanently in an 'off' state to provide electrical isolation between devices on either side of the dummy gate structure. However, adding more front-side contacts to the gate and source regions to form these gate tie-downs increases the routing complexity for front-side interconnects and produces inefficient routing designs.

Thus, and in accordance with an embodiment of the present disclosure, techniques are provided herein to use lithographic operations to directly etch cavities through one or more backside dielectric materials to expose the bottom surfaces of a given transistor gate and source region. The cavities may then be filled with any number of conductive materials to form a first backside contact beneath the gate structure and a second backside contact beneath the source region. According to some embodiments, a reactive ion etching (RIE) processing may be used on the backside to expose the bottom surfaces of the gate structure and source region, which yields backside cavities having inwardly tapered sidewalls. Due to this tapering, the width of the resulting backside contacts also tapers. In one example, a bottom surface of the first backside contact (e.g., away from the gate structure) is wider (e.g., at least 3 nm wider) than a width of the first backside contact at the bottom surface of the gate structure. The location of the first backside contact may be lithographically patterned to land within the width of the gate structure, which may be, for example, less than 30 nm, such as between 15 nm and 25 nm. Similarly, the location of the second backside contact may be lithographically patterned to land within the width of the source region, which may also be, for example, less than 30 nm. In some other embodiments, the first backside contact beneath the gate structure is formed using backside lithography while the second backside contact beneath the source region is formed using a self-aligned process. For example, the self-aligned process uses a sacrificial material formed beneath the source region during frontside processing, which is later removed from the backside to form a self-aligned cavity beneath the source region. The second contact is then formed within the self-aligned cavity.

According to an embodiment, an integrated circuit includes a semiconductor device having a semiconductor region extending in a first direction from a first source region to a second source or drain region and a gate structure extending in a second direction, different from the first direction, over the semiconductor region, a dielectric structure beneath the gate structure, the first source region, and the second source or drain region, a first backside conductive contact extending through the dielectric structure and contacting a bottom surface of the gate structure, a second backside conductive contact extending through the dielectric structure and contacting a bottom surface of the first source region, and a conductive layer beneath the dielectric structure. Both the first backside conductive contact and the second backside conductive contact directly contact the conductive layer.

According to another embodiment, an electronic device includes a chip package having one or more dies. At least one of the one or more dies includes a semiconductor region extending in a first direction from a first source region to a second source or drain region, a gate structure extending in a second direction, different from the first direction, over the semiconductor region, a dielectric structure beneath the gate structure, the first source region, and the second source or drain region, a first backside conductive contact extending through the dielectric structure and contacting a bottom surface of the gate structure, and a second backside conductive contact extending through the dielectric structure and contacting a bottom surface of the first source region. The first backside conductive contact has a tapered width along the first direction such that a first width of the first backside conductive contact at a bottom surface of the dielectric structure is greater than a second width of the first backside conductive contact at the bottom surface of the gate structure.

According to another embodiment, a method of forming an integrated circuit includes: forming a fin comprising semiconductor material, the fin extending above a substrate; forming a dielectric layer adjacent to a subfin of the fin; forming a sacrificial gate and spacer structures over the fin; removing portions of the fin not covered by the sacrificial gate and spacer structures; forming source and drain regions at exposed ends of the semiconductor material and over the subfin; replacing the sacrificial gate with a gate structure; removing a portion of the substrate from a backside of the integrated circuit; removing the subfin from the backside and replacing the subfin with a dielectric fill; etching a first cavity through the dielectric fill such that a bottom surface of the gate structure is exposed within the first cavity; etching a second cavity through the dielectric fill such that a bottom surface of the source region is exposed within the second cavity, the second cavity being adjacent to the first cavity; and forming a first conductive contact in the first cavity and a second conductive contact in the second cavity.

According to another embodiment, an integrated circuit includes a semiconductor device having a semiconductor region extending in a first direction from a first source region to a second source or drain region and a gate structure extending in a second direction, different from the first direction, over the semiconductor region, a dielectric structure beneath the gate structure, the first source region, and the second source or drain region, a first backside conductive contact extending through the dielectric structure and contacting a bottom surface of the gate structure, and a second backside conductive contact extending through the dielectric structure and contacting a bottom surface of the first source region. A distance along the first direction between the first backside conductive contact and the second backside conductive contact is, for example, less than 10 nm.

The techniques can be used with any type of non-planar transistors, including finFETs (sometimes called double-gate transistors, or tri-gate transistors), or nanowire and nanoribbon transistors (sometimes called gate-all-around transistors), or stacked versions of any of these architectures, to name a few examples. The source and drain regions can be, for example, doped portions of a given fin or substrate or epitaxial regions that are deposited during an etch-and-replace source/drain forming process. The dopant type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of backside contacts beneath one or more gate structures and source regions adjacent to the one or more gate structures, wherein the backside contacts at least beneath the gate structures have a tapered profile that is indicative of a backside RIE process (e.g., the width of the contact decreases as it rises up towards the bottom surface of the gate structure). According to some embodiments, a backside conductive layer would be present to short between any number of the backside contacts.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. Multiple formed layers of the same material (e.g., a same dielectric material) on one another may be collectively considered a single layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

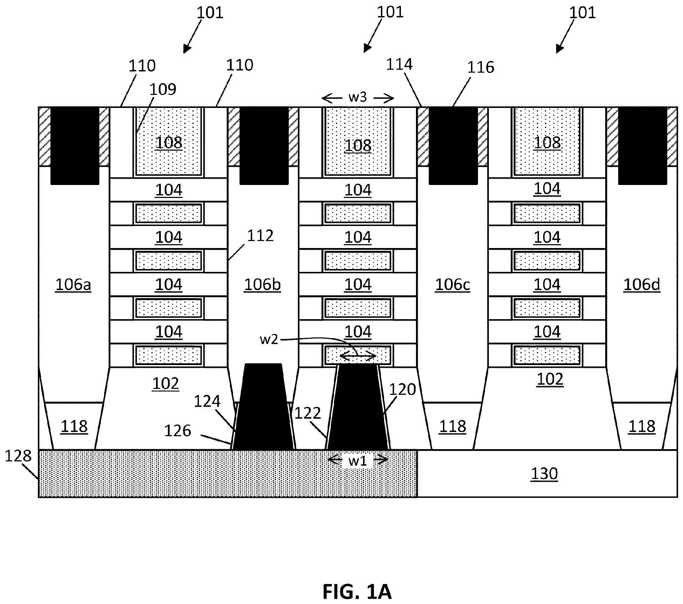

Figure 1A is a cross-section view taken through semiconductor devices 101 along a 'fin' direction that illustrates the semiconductor bodies extending between source or drain regions of each of the semiconductor devices, in accordance with an embodiment of the present disclosure. Each of the semiconductor devices may be, for instance, non-planar metal oxide semiconductor (MOS) transistors, such as tri-gate (e.g., finFET) or gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions). Other examples may have a forksheet structure having a p-type device and an n-type device separated by a dielectric spine or structure. Any of semiconductor devices 101 may be p-channel devices (e.g., PMOS) or n-channel devices (e.g., NMOS).

The semiconductor material used in each of the semiconductor devices may be formed from or on a semiconductor substrate. According to some embodiments, the substrate is removed following the completion of all topside processing and is replaced with a base dielectric layer 102. Base dielectric layer 102 may represent any number of dielectric layers and/or materials. In some examples, base dielectric layer 102 includes one or more layers of silicon dioxide.

The one or more semiconductor regions of the devices may include fins that can be, for example, native to the substrate (formed from the substrate itself), such as silicon fins etched from a bulk silicon substrate. Alternatively, the fins can be formed of material deposited onto the substrate. In one such example case, a blanket layer of SiGe can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. Again, the alternating layers can be blanket deposited and then etched into fins or deposited into fin-shaped trenches, in some examples.

Semiconductor devices 101 include one or more semiconductor regions (also called channel regions), such as one or more nanoribbons 104 extending between epitaxial source or drain regions 106a - 106d (collectively referred to as source or drain regions 106) in the first direction. Any of source or drain regions 106 may act as either a source region or a drain region, depending on the application and dopant profile. Any semiconductor materials suitable for source and drain regions can be used (e.g., group IV and group III-V semiconductor materials) for any of the illustrated source or drains regions 106. In any such cases, the composition and doping of source or drain regions 106 may be the same or different, depending on the polarity of the transistors. In an example, p-channel devices have a high concentration of p-type dopants in the associated source or drain regions 106, and n-channel devices have a high concentration of n-type dopants in the associated source or drain regions 106. Example p-type dopants include boron and example n-type dopants include phosphorous or arsenic. Any number of source and drain configurations and materials can be used. In some examples, p-type source or drain regions 106 include silicon germanium doped with boron and n-type source or drain regions 106 include silicon doped with phosphorous.

A gate structure extends over nanoribbons 104 of each semiconductor device 101 in a second direction (e.g., into and out of the page) to form the transistor gate of each corresponding semiconductor device 101. Each gate structure may include a corresponding gate electrode 108 and gate dielectric 109. Gate electrode 108 may be made up of a conductive fill and one or more metal workfunction layers, according to some embodiments. Gate dielectric 109 may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), or doped polysilicon. In some embodiments, p-channel devices have a gate electrode 108 with one or more workfunction layers of tantalum nitride (TaN) and/or tungsten (W). In some embodiments, n-channel devices have a gate electrode 108 with one or more workfunction layers of titanium aluminum carbide.

Gate dielectric 109 may include any suitable gate dielectric material(s). In some embodiments, gate dielectric 109 includes a layer of native oxide material (e.g., silicon dioxide germanium dioxide, or SiGe oxide) on nanoribbons 104, and a layer of high-k dielectric material (e.g., hafnium oxide or aluminum oxide) on the native oxide.

According to some embodiments, spacer structures 110 and inner spacers 112 are present along the sidewalls of gate structures 108. Spacer structures 110 and inner spacers 112 may be any suitable dielectric material, such as silicon nitride, and provide separation between a given gate structure and the adjacent source or drain region 106. Inner spacers 112 may separate adjacent nanoribbons 104 from one another along a third direction (e.g., a vertical direction).

According to some embodiments, a dielectric fill 114 may be present over the source or drain regions 106 within the corresponding source/drain trenches of semiconductor devices 101. A top surface of dielectric fill 114 may be substantially co-planar with a top surface of spacer structures 110. Dielectric fill 114 may include any suitable dielectric material, such as silicon dioxide, in some examples.

According to some embodiments, any number of frontside contacts 116 are provided through dielectric fill 114 and contacting a top portion of source or drain regions 106. Frontside contacts 116 can include any suitable conductive material, such as tungsten, molybdenum, ruthenium, cobalt, or other metals. Frontside contacts 116 may be formed during the same metal deposition process(es) such that they all include the same conductive material.

According to some embodiments, one or more of source or drain regions 106 have a dielectric cap 118 on its bottom surface. Dielectric cap 118 may extend through a portion of base dielectric layer 102. Dielectric caps 118 may directly contact the bottommost surfaces of their corresponding source or drain regions 106 and may include any suitable dielectric material having sufficient etch selectivity to the dielectric material of base dielectric layer 102. Example materials for dielectric cap 118 include silicon nitride or silicon oxynitride. Dielectric cap 118 and base dielectric layer 102 may together be part of a base dielectric structure beneath the semiconductor devices. Accordingly, the base dielectric structure can include any number of different dielectric layers and/or materials.

According to some embodiments, a first backside contact 120 is provided beneath a corresponding gate structure. In the illustrated example, first backside contact 120 directly contacts the bottom surface of the middle gate electrode 108. First backside contact 120 may include any of the same materials noted above for frontside contacts 116. In some examples, first backside contact 120 and frontside contacts 116 include the same conductive material. According to some embodiments, additional dielectric layers and conductive elements can be formed beneath base dielectric layer 102 to create a backside interconnect structure (such as a power delivery network and/or signal routing network).

According to some embodiments, a first dielectric liner 122 is present around portions of first backside contact 120, such as between first backside contact 120 and base dielectric layer 102. First dielectric liner 122 may be formed within a backside cavity prior to the formation of first backside contact 120, such that first backside contact 120 punches through a portion of first dielectric liner 122 to contact the bottom of the gate structure. In some embodiments, first backside contact 120 also punches through gate dielectric 109 to directly contact gate electrode 108. First dielectric liner 122 may be any suitable dielectric material, such as silicon nitride, silicon oxycarbonitride, aluminum oxide, or titanium nitride. First dielectric liner 122 may have a thickness of, for example, less than 5 nm, or between 1 nm and 3 nm.

According to some embodiments, the width of first backside contact 120 tapers inwards as it rises towards the bottom surface of gate electrode 108. As noted above, this tapering may be caused by the backside RIE process to form the cavity beneath the gate structure. In some examples, a first width (w1) of first backside contact 120 along the first direction at the bottom surface of base dielectric layer 102 is greater than a second width (w2) of first backside contact 120 along the first direction at the bottom surface of the gate structure by, for example, at least 3 nm. First backside contact 120 is lithographically aligned to land on the bottom surface of the gate structure, which itself has a width (w3) along the first direction that is, for example, less than 30 nm, such as between 15 nm and 25 nm.

According to some embodiments, a second backside contact 124 is provided beneath a source region 106b adjacent to the gate structure with first backside contact 120. In the illustrated example, second backside contact 124 contacts the bottom surface of source region 106b and extends into source region 106b. Second backside contact 124 may include any of the same materials noted above for first backside contact 120. In some examples, first backside contact 120 and second backside contact 124 include the same conductive material.

According to some embodiments, a second dielectric liner 126 is present around portions of second backside contact 124, such as between second backside contact 124 and base dielectric layer 102. Second dielectric liner 126 may be formed within a backside cavity prior to the formation of second backside contact 124, such that second backside contact 124 punches through a portion of second dielectric liner 126 to contact source region 106b. Second dielectric liner 124 may have any of the same materials and have the same range of thicknesses as noted above for first dielectric liner 122.

According to some embodiments, both first backside contact 120 and second backside contact 124 are shorted together using a backside conductive line 128. A backside interconnect layer may include a backside dielectric layer 130 and backside conductive line 128. Backside conductive line 128 may include any suitable conductive material, such as such as tungsten, molybdenum, ruthenium, cobalt, or other metals. In some embodiments, the backside interconnect layer is one layer of a backside interconnect region that may include any number of similar interconnect layers to route signal and power to various transistor elements. In the illustrated example, the gate electrode 108 and source region 106b of the middle semiconductor device 101 are shorted to effectively bias the middle semiconductor device 101 in an "off" state, such that the device acts as an electrical isolation structure between the adjacent semiconductor devices 101 along the first direction. For example, the leftmost device 101 may have a drain region 106a and source region 106b, while the rightmost device has a drain region 106c and a source region 106d. The middle device 101 does not operate as a switching transistor due to the short between its gate and source.

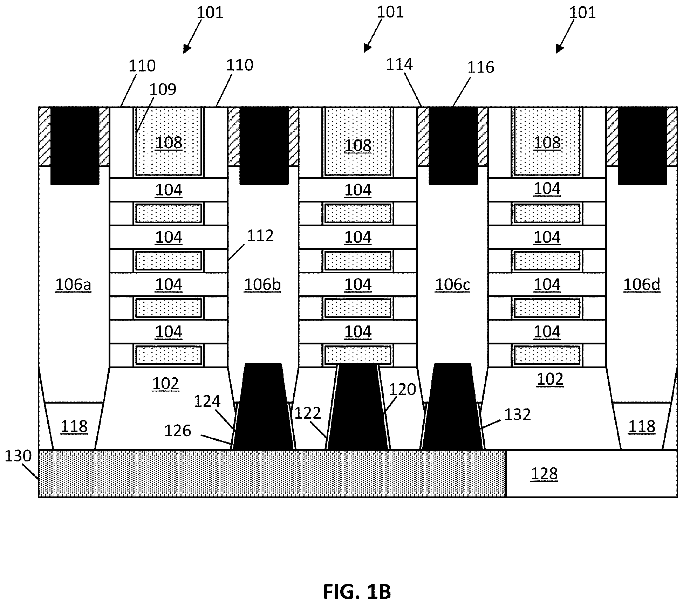

Other circuit designs or applications may have the source or drain regions arranged differently. For example, Figure 1B illustrates an example where the devices 101 on either ends of the middle device 101 have their sources on either side of the middle device 101. In other words, the leftmost device 101 has a drain region 106a and a source region 106b, while the rightmost device has a drain region 106d and a source region 106c. In this arrangement, both source regions 106b and 106c may be shorted to the gate of the middle device. Thus, according to an embodiment, a third backside contact 132 is provided to contact the bottom of source region 106c. Third backside contact 132 may be similar to second backside contact 124 discussed above.

In either structure shown in Figure 1A or 1B, the middle semiconductor "dummy" device 101 may have a relatively higher threshold voltage (Vt) compared to neighboring "active" transistors. The threshold voltage may be higher to reduce current leakage across the nanoribbons 104 of the middle device 101. Several techniques can be used to increase the threshold voltage of the device. In one example, different gate electrode materials, such as different work function metals, may be used for the middle device compared to other devices that cause an increase in Vt. In another example, counter-dopants may be implanted into the nanoribbons 104 of the middle device to reduce current leakage. For example, p-type dopants may be implanted into nanoribbons 104 of the center device if source region 106b and source or drain region 106c include n-type dopants, and vice versa.

### Fabrication Methodology

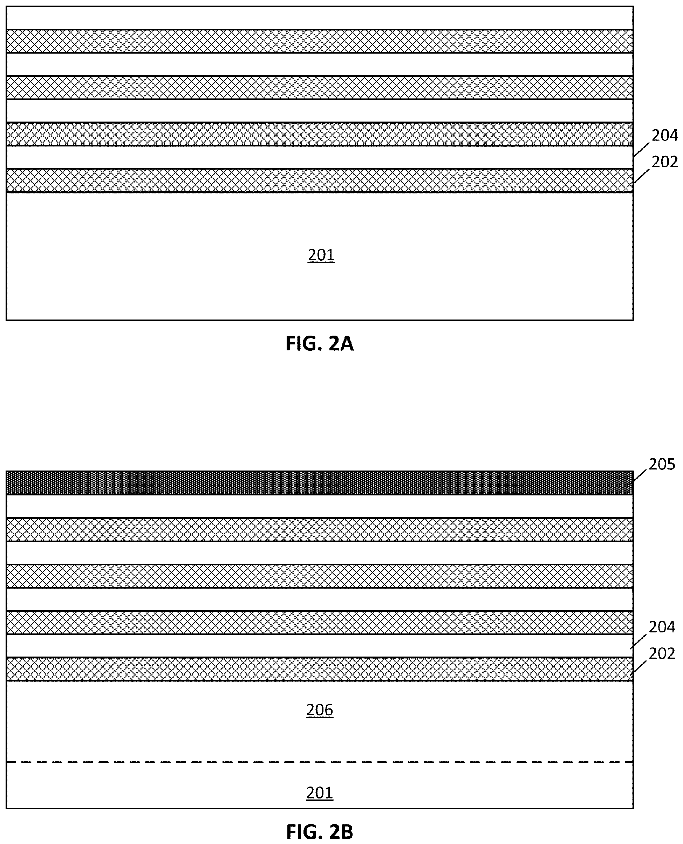

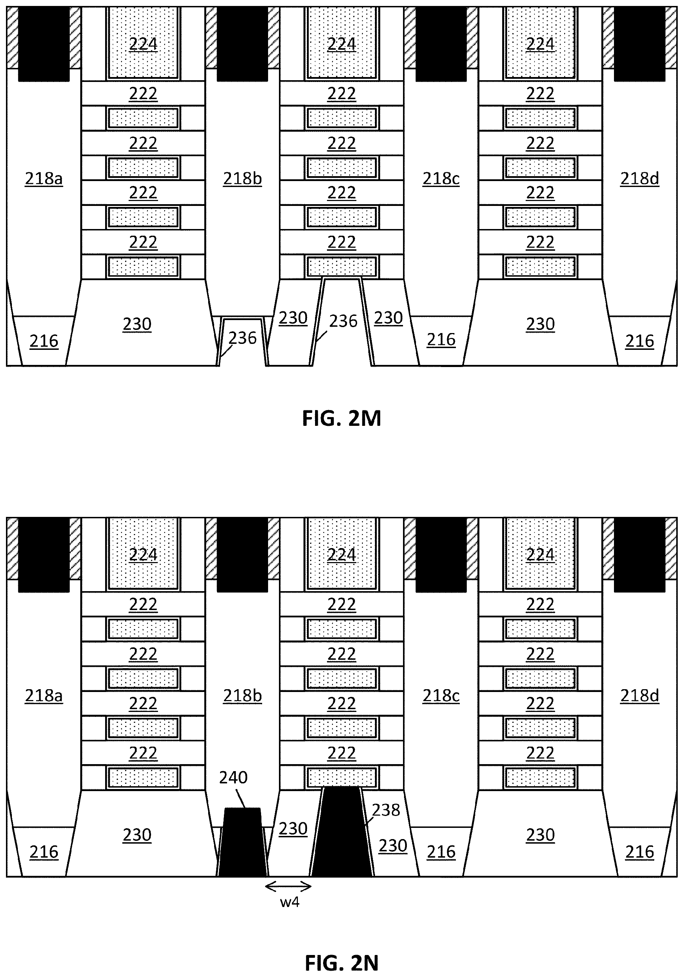

Figures 2A - 2O include cross-sectional views that collectively illustrate an example process for forming an integrated circuit configured with backside contacts beneath a gate structure and an adjacent source region, in accordance with some embodiments of the present disclosure. Figures 2A - 2O represent a similar cross-sectional view as that of Figure 1A across a series of semiconductor devices. The depicted structure evolves as the process flow continues, culminating in the structure shown in Figure 2N, which is similar to the structure shown in Figure 1A. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Although only two backside contacts are shown in the fabrication process, it should be understood that any number of backside contacts can be formed across the integrated circuit using the same process described herein.

Figure 2A illustrates a cross-sectional view taken through a substrate 201 having a series of material layers formed over substrate 201, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or SiGe), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 include a semiconductor material suitable for use as a nanoribbon such as silicon (Si), SiGe, germanium, or III-V materials like indium phosphide (InP) or gallium arsenide (GaAs). Sacrificial layers 202 include a material that can be selectively removed relative to semiconductor layers 204. In some examples, for instance, semiconductor layers 204 are silicon and sacrificial layers 202 are SiGe, or vice-versa. In some other examples where SiGe is used in each of semiconductor layers 204 and in sacrificial layers 202, the germanium concentration is different between semiconductor layers 204 and sacrificial layers 202, so as to allow for etch selectivity. For example, semiconductor layers 204 may include a higher germanium content compared to sacrificial layers 202.

While dimensions can vary from one example embodiment to the next, the thickness of each semiconductor layer 204 may be between about 5 nm and about 20 nm, in some examples. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any material deposition technique, such as chemical vapor deposition (CVD), plasma-enhanced chemical vapor deposition (PECVD), physical vapor deposition (PVD), or atomic layer deposition (ALD), or epitaxial growth.

Figure 2B depicts a cross-section view of the structure shown in Figure 2A following the formation of a cap layer 205 and the subsequent formation of fins beneath cap layer 205, according to an embodiment. Cap layer 205 may be any suitable hard mask material such as a carbon hard mask (CHM) or silicon nitride. Cap layer 205 is patterned into rows to form corresponding rows of fins from the alternating layer stack of sacrificial layers 202 and semiconductor layers 204. Cap layer 205 extends along the top of each fin in a first direction.

According to some embodiments, an anisotropic etching process through the layer stack continues into at least a portion of substrate 201. Portions of substrate 201 beneath the fins are not etched and yield subfin regions 206. The etched portions of substrate 201 that are not under the fins may be filled with a dielectric fill that acts as shallow trench isolation (STI) between adjacent fins. The dielectric fill is not shown in these cross-sections as it extends in the first direction along the sides of subfin regions 206 that are into and out of the page. The dielectric fill may be any suitable dielectric material such as silicon dioxide. The subfin regions 206 represent remaining portions of substrate 201 flanked by the dielectric fill, according to some embodiments.

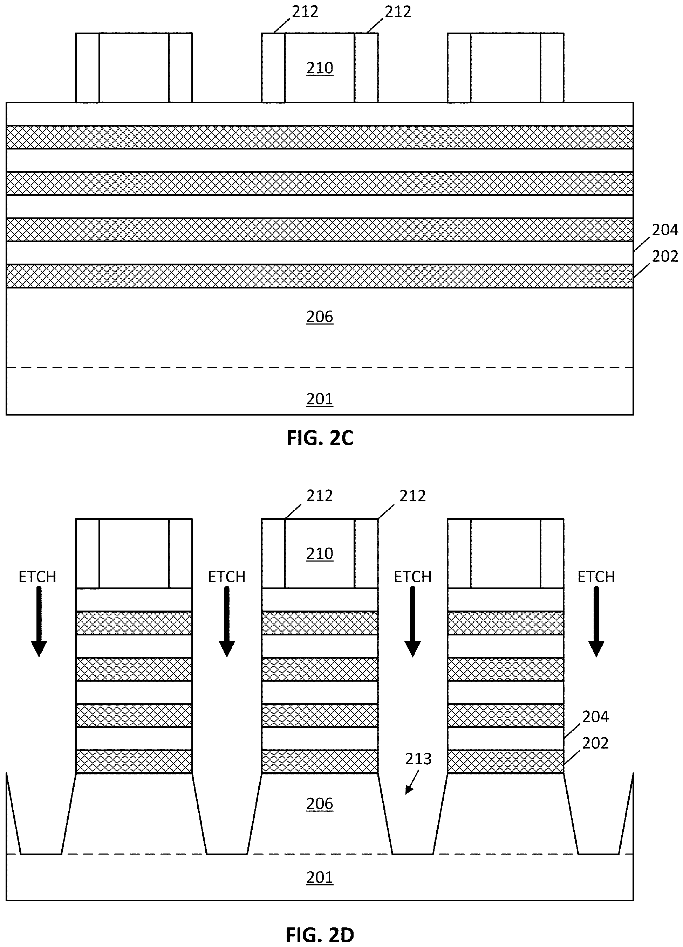

Figure 2C depicts a cross-section view of the structure shown in Figure 2B following the formation of sacrificial gates 210 and spacer structures 212, according to some embodiments. A gate masking layer may first be patterned in strips that extend orthogonally across each of the fins (e.g., in a second direction) in order to form corresponding sacrificial gates 210 in strips beneath the gate masking layers. Afterwards, the gate masking layers may be removed or may remain as a cap layer above each sacrificial gate 210. According to some embodiments, the sacrificial gate material is removed in all areas not protected by the gate masking layers. Sacrificial gate 210 may be any suitable material that can be selectively removed without damaging the semiconductor material of the fins. In some examples, sacrificial gate 210 includes polysilicon.

According to some embodiments, spacer structures 212 are formed along the sidewalls of sacrificial gates 210. Spacer structures 212 may be conformally deposited (e.g., using CVD or ALD) and then etched back or otherwise removed (e.g., via anisotropic or directional etch) from horizontal surfaces, such that spacer structures 212 remain mostly on sidewalls of any exposed structures. The width of spacer structures 212 (along the first direction) may vary from one example to the next, but in some cases is in the range of 3 nm to 20 nm. According to some embodiments, spacer structures 212 may be any suitable dielectric material, such as silicon nitride, silicon carbon nitride, or silicon oxycarbonitride. In one such embodiment, spacer structures 212 comprise a nitride and the dielectric fill adjacent to subfin regions 206 comprises an oxide, so as to provide a degree of etch selectivity during final gate processing.

Figure 2D depicts a cross-section view of the structure shown in Figure 2C following the removal of exposed portions of the fins not protected by sacrificial gates 210 and spacer structures 212, according to some embodiments. The exposed fin portions may be removed using any anisotropic etching process, such as RIE or other directional etch process. The removal of the exposed fin portions creates source/drain trenches that alternate with gate trenches (currently filled with sacrificial gates 210) along the first direction, according to some embodiments. In some embodiments, at least a portion of subfin regions 206 is also removed such that a top surface of subfin regions 206 is recessed below a top surface of the adjacent dielectric fill. In some embodiments, subfin regions 206 within the source/drain trenches are removed entirely (as illustrated), to yield subfin cavities 213. Note that due to the deep etching process, the source/drain trenches may exhibit a tapering width as they extend deeper. Accordingly, at least subfin cavities 213 may have a tapering width, as illustrated.

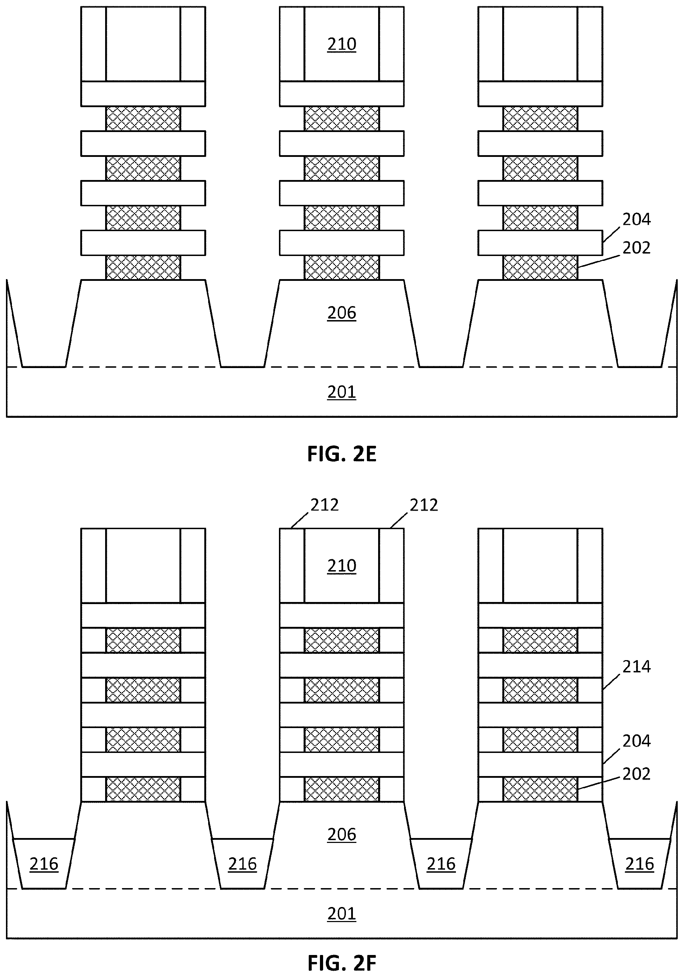

Figure 2E depicts a cross-section view of the structure shown in Figure 2D following the removal of portions of sacrificial layers 202, according to an embodiment of the present disclosure. An isotropic etching process may be used to selectively recess the exposed ends of each sacrificial layer 202 (e.g., while etching comparatively little of semiconductor layers 204).

Figure 2F depicts a cross-section view of the structure shown in Figure 2E following the formation of internal spacers 214, according to an embodiment of the present disclosure. Internal spacers 214 may have a material composition that is similar to or the exact same as spacer structures 212. Accordingly, internal spacers 214 may be any suitable dielectric material that exhibits high etch selectively to semiconductor materials such as silicon and/or silicon germanium. Internal spacers 214 may be, for example, conformally deposited over the sides of the fin structure using a conformal deposition process like CVD or ALD and then etched back using an isotropic etching process to expose the ends of semiconductor layers 204. According to some embodiments, internal spacers 214 have a similar width (e.g., along the first direction) to spacer structures 212. According to some embodiments, a portion of the dielectric material used to form internal spacers 214 remains at the bottom of the source/gate trenches as one or more dielectric caps 216. Accordingly, each of dielectric caps 216 may have the same material composition as internal spacers 214. Dielectric caps 216 may fill a portion of subfin cavities 213 and may exhibit the same tapering width profile as subfin cavities 213.

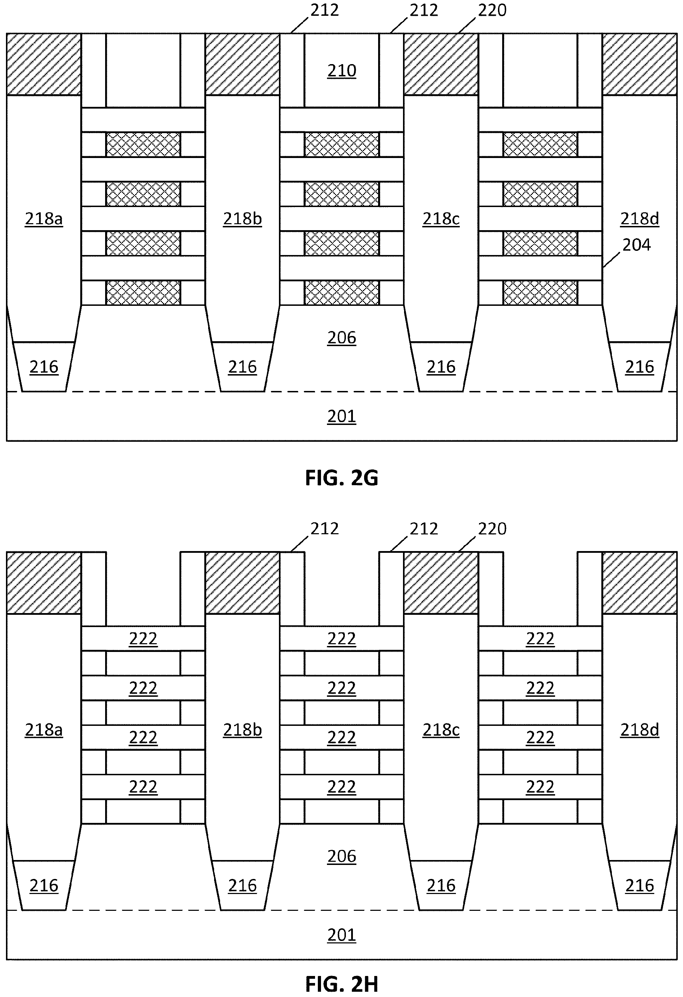

Figure 2G depicts a cross-section view of the structure shown in Figure 2F following the formation of source or drain regions 218a - 218d (collectively referred to as source or drain regions 218) within the source/drain trenches, according to some embodiments. Source or drain regions 218 may be formed in the areas that had been previously occupied by the exposed fins between spacer structures 212. According to some embodiments, source or drain regions 218 are epitaxially grown from the exposed semiconductor material at the ends of semiconductor layers 204. Note that lower portions of source or drain regions 218 may also be grown from the exposed sidewalls surfaces of subfin region 206. According to some embodiments, source or drain regions 218 are formed directly over dielectric caps 216, such that dielectric caps 216 contact the bottom surfaces of source or drain regions 218.

According to some embodiments, a dielectric fill 220 is provided over source or drain regions 218. In some examples, dielectric fill 220 occupies a remaining volume within the source/drain trenches around and over portions of source or drain regions 218. Dielectric fill 220 may be any suitable dielectric material, such as silicon dioxide. In some examples, dielectric fill 220 extends up to and planar with a top surface of spacer structures 212 (e.g., following a polishing procedure).

Figure 2H depicts a cross-section view of the structure shown in Figure 2G following the removal of sacrificial gates 210 and sacrificial layers 202, according to some embodiments. In examples where gate masking layers are still present, they may be removed at this time. Once sacrificial gates 210 are removed, the remaining fin portions extending between spacer structures 212 are exposed.

In the example where the fins include alternating sacrificial layers 202 and semiconductor layers 204, sacrificial layers 202 are selectively removed to leave behind nanoribbons 222 extending between corresponding source or drain regions 218. Each vertical set of nanoribbons 222 represents the semiconductor region (also called channel region) of a different semiconductor device. It should be understood that any of nanoribbons 222 may also be nanowires or nanosheets. Sacrificial gates 210 and sacrificial layers 202 may be removed using the same isotropic etching process or different isotropic etching processes.

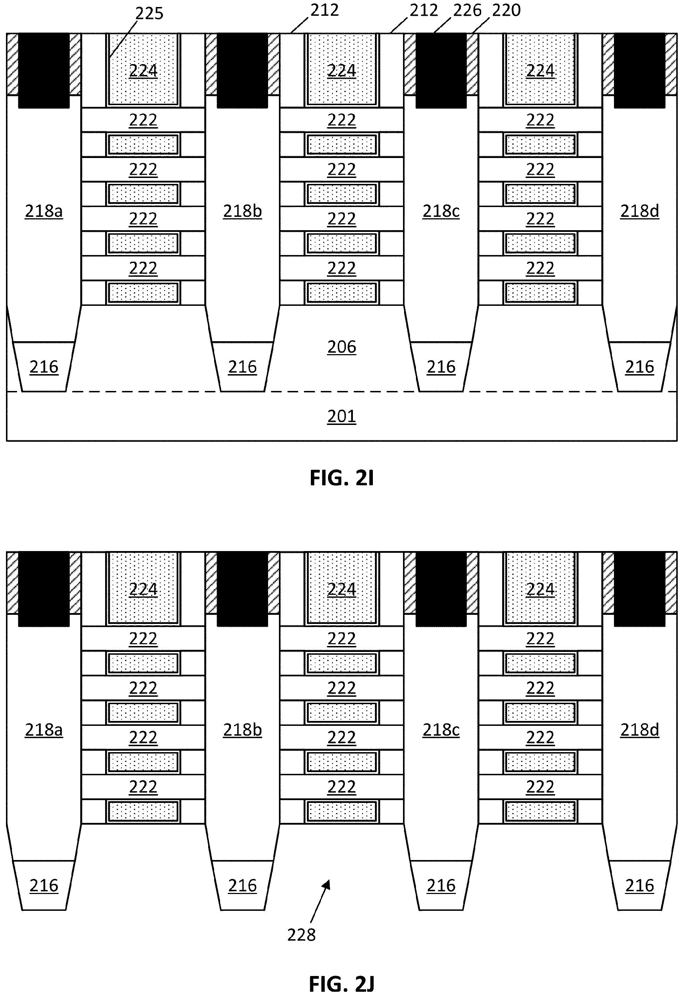

Figure 2I depicts a cross-section view of the structure shown in Figure 2H following the formation of gate structures around the suspended nanoribbons 222, according to an embodiment of the present disclosure. As noted above, each gate structure includes a gate electrode 224 and a gate dielectric 225.

The gate dielectric 225 may be conformally deposited around nanoribbons 222 using any suitable deposition process, such as ALD. Gate dielectric 225 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 225 is hafnium oxide with a thickness between about 1 nm and about 5 nm. In some embodiments, gate dielectric 225 may include one or more silicates (e.g., titanium silicate, tungsten silicate, niobium silicate, and silicates of other transition metals). Gate dielectric 225 may be a multilayer structure, in some examples. For instance, gate dielectric 225 may include a first layer on the nanoribbons, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 225 to improve its quality when a high-k dielectric material is used. In some embodiments, the high-k material can be nitridized to improve its aging resistance.

The gate electrode 224 may be deposited over gate dielectric 225 and can be any standard or proprietary conductive material that may include any number of gate cuts. In some embodiments, gate electrode 224 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 224 may include, for instance, one or more workfunction layers, resistance-reducing layers, and/or barrier layers. P-type workfunction layers include, for example, tungsten, and n-type workfunction layers include, for example, titanium aluminum carbide.

According to some embodiments, frontside contacts 226 may be formed through dielectric fill 220 to contact the top surfaces of source or drain regions 218. Frontside contacts 226 may include any suitable conductive material, such as tungsten, cobalt, molybdenum, or ruthenium, for making electrical contact with the underlying source or drain regions 218. Although not illustrated, any number of frontside interconnect layers may be formed over the semiconductor devices. The interconnect layers include dielectric layers, conductive vias, and conductive layers to carry power and/or signals to various transistor elements.

Figure 2J depicts a cross-section view of the structure shown in Figure 2I following the removal of substrate 201. Any number of polishing, grinding, or etching processes may be used to remove the bulk portion of substrate 201. According to some embodiments, substrate 201 is removed until a bottom surface of dielectric caps 216 and/or a bottom surface of the dielectric fill adjacent to subfin regions 206 are exposed. The backside exposed subfin regions 206 may then be etched away using an isotropic etching process. According to some embodiments, the removal of subfin regions 206 yields backside recesses 228 between portions of source or drain regions 218 with dielectric caps 216 at their tips extending downward away from the bottom surface of the gate structures.

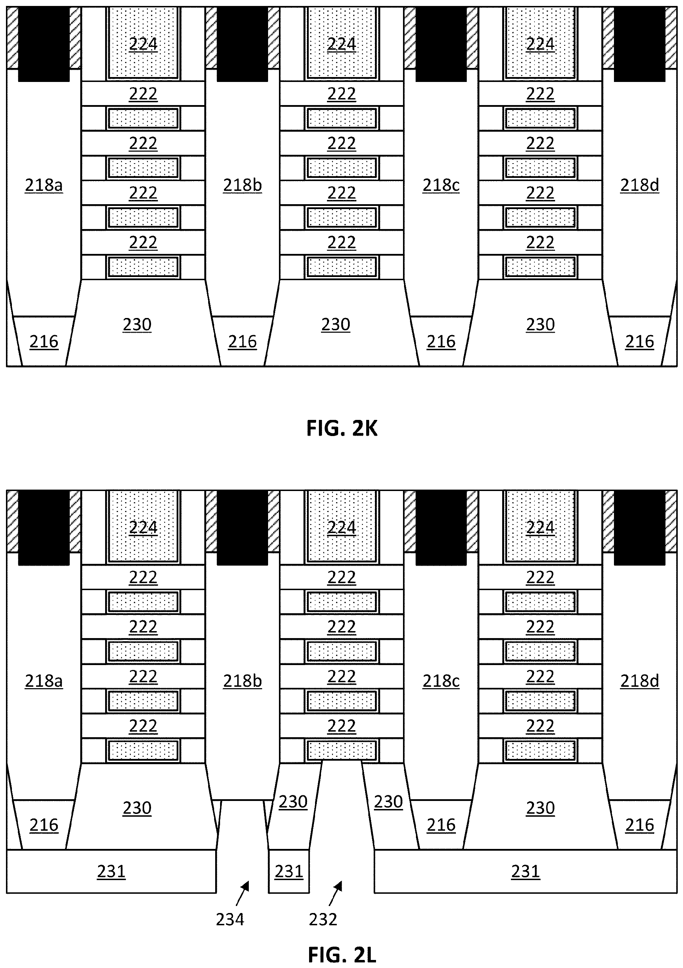

Figure 2K depicts a cross-section view of the structure shown in Figure 2J following the formation of a base dielectric structure 230 within backside recesses 228, according to some embodiments. One or more dielectric materials or layers may be deposited to form base dielectric structure 230. Furthermore, base dielectric structure 230 may also include the dielectric fill adjacent to backside recesses 228 into and out of the page. In some examples, base dielectric structure 230 is considered to also include dielectric caps 216. Base dielectric structure 230 may include any suitable dielectric material, such as silicon dioxide. According to some embodiments, a bottom surface of base dielectric structure 230 may be polished to be a substantially planar surface. The planar bottom surface of base dielectric structure 230 may be coplanar with a bottom surface of dielectric caps 216 or may be lower than the bottom surface of dielectric caps 216.

Figure 2L depicts a cross-section view of the structure shown in Figure 2K following the formation of a masking layer 231 on the backside of the structure, according to some embodiments. Masking layer 231 may be a photoresist material or a dielectric material that has a high etch selectivity with the dielectric material of base dielectric structure 230.

According to some embodiments, masking layer 231 is patterned and etched to form any number of openings through masking layer 231, such as a first opening beneath a gate structure and a second opening beneath an adjacent source region 218b. A subsequent directional etching process may then be performed to create a first backside cavity and second backside cavity 234, according to some embodiments. An RIE process may be used to anisotropically etch through the exposed portions of any exposed dielectric materials/layers not protected by masking layer 231. In an example, first backside cavity 232 extends only through base dielectric structure 230 to expose a bottom surface of the gate structure while second backside cavity 234 extends at least partially through dielectric cap 216 to expose a bottom surface of source region 218b. As a result of the etching process, each of first backside cavity 232 and second backside cavity 234 has a tapering profile with a width that decreases from the opening of the cavity (e.g., at the bottom surface of base dielectric structure 230) towards the bottom surface of the gate structure or source region, according to some embodiments. According to some embodiments, the etching process to form first backside cavity 232 also removes a portion of gate dielectric 225 to expose a bottom surface of gate electrode 224 within first backside cavity 232.

In some examples, first backside cavity 232 has a greatest width along the bottom surface of base dielectric structure 230 that is between about 15 nm and about 20 nm and a smallest width at the bottom surface of the gate structure that is between about 10 nm and about 15 nm. Due to standard alignment error, the alignment of first backside cavity 232 beneath the gate structure may not be perfect such that first backside cavity 232 is offset along the first direction from the center of gate electrode 224 by, for example, up to 5 nm. Similarly, the alignment of second backside cavity 234 beneath source region 218b may not be perfect such that second backside cavity 234 is offset along the first direction from the center of source region 218b by, for example, up to 5 nm.

Figure 2M depicts a cross-section view of the structure shown in Figure 2L following the formation of a dielectric liner 236, according to some embodiments. Dielectric liner 236 may be any suitable dielectric material, such as silicon nitride, aluminum oxide, or titanium nitride, and may have a thickness, for example, between about 1 nm and about 3 nm. Dielectric liner 236 may be deposited using any suitable conformal deposition technique, such as chemical vapor deposition (CVD), plasma-enhanced chemical vapor deposition (PECVD), or atomic layer deposition (ALD). Dielectric liner 236 may be formed such that is covers the sidewalls of both first backside cavity 232 and second backside cavity 234 and the exposed bottom surfaces of the gate structure and source region 218b. In some examples, portions of dielectric liner 236 deposited along the bottom surface of base dielectric structure 230 are removed (e.g., via chemical mechanical polishing). In some other examples, portions of dielectric liner 236 continue to extend along the bottom surface of base dielectric structure 230.

Figure 2N depicts a cross-section view of the structure shown in Figure 2M following the formation of a first backside contact 238 within first backside cavity 232 and a second backside contact 240 within second backside cavity 234, according to some embodiments. Each of first backside contact 238 and second backside contact 240 may include any suitable conductive material, such as any of tungsten, ruthenium, molybdenum, or cobalt. Prior to the deposition of conductive material to form the backside contacts, a directional etch (e.g., RIE) is performed to punch through the portion of dielectric liner 236 on the bottom surface of both the gate structure and source region 218b, according to some embodiments. In some examples, this directional etch also punches through gate dielectric 225, if it is still present, to expose the bottom surface of gate electrode 224. In any case, first backside contact 238 is formed directly on the bottom surface of gate electrode 224, according to some embodiments. The directional etch used to punch through dielectric liner 236 on the bottom surface of source region 218b may also etch away a portion of source region 218b, such that second backside contact 240 extends into a portion of source region 218b, according to some embodiments. In other examples, second backside contact 240 lands on the bottom surface of source region 218b and does not extend into source region 218b.

Due to the tapering profile, the width of first backside contact 238 may be, for example, about 3 nm greater, or between 2 nm and 5 nm greater, at the bottom surface of base dielectric structure 230 compared to the bottom surface of the gate structure. In some examples, first backside contact 238 has a greatest width along the bottom surface of base dielectric structure 230 that is between about 15 nm and about 20 nm and a smallest width at the bottom surface of the gate structure that is between about 10 nm and about 15 nm. As noted above, alignment error when performing the etching process may cause first backside contact 238 to be offset from the center of the gate structure along the first direction by, for example, up to 3 nm or up to 5 nm.

The relative size of first backside contact 238 compared to second backside contact 240 is not intended to be drawn to scale. In some examples, second backside contact 240 is wider at its base (along the bottom surface of base dielectric structure 230) compared to the base of first backside contact 238. In some examples, second backside contact 240 extends further into source region 218b, such that second backside contact 240 extends above the top surface of first backside contact 238 (e.g., above the bottom surface of the gate structure). A shortest distance w4 along the first direction between first backside contact 238 and second backside contact 240 may be, for example, between about 3 nm and about 8 nm, such as around 5 nm, according to some embodiments. It should be understood that the taped sidewalls of second backside contact 240 may be a product of the backside directional etching process, and that other fabrication processes used to form second backside contact 240 may not result in tapered sidewalls.

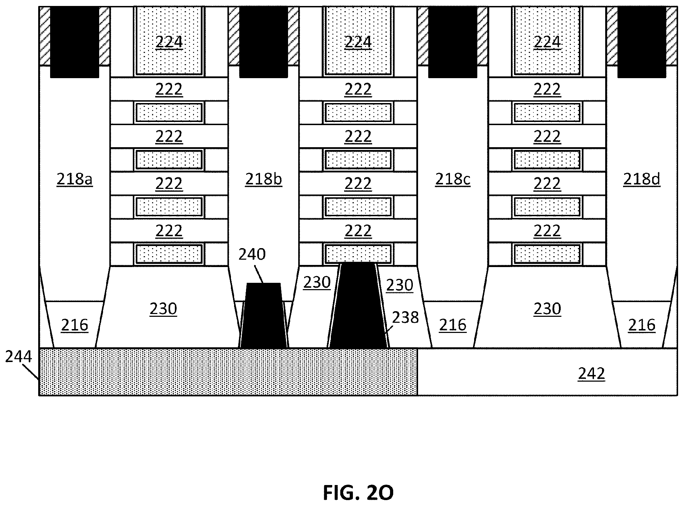

Figure 2O depicts a cross-section view of the structure shown in Figure 2N following the formation a first backside interconnect layer, according to some embodiments. Any number of backside interconnect layers may be formed to provide a shorted connection between first backside contact 238 and second backside contact 240. According to some embodiments, the first backside interconnect layer includes a backside dielectric layer 242 and a backside conductive trace 244. Backside conductive trace 244 may contact a bottom surface of each of first backside contact 238 and second backside contact 240 to short them together. Any number of other backside interconnect layers may be formed beneath the first backside interconnect layer. Backside dielectric layer 242 may be any suitable dielectric material, such as silicon dioxide. Backside conductive trace 244 may be any suitable conductive material, such as any of tungsten, ruthenium, molybdenum, or cobalt.

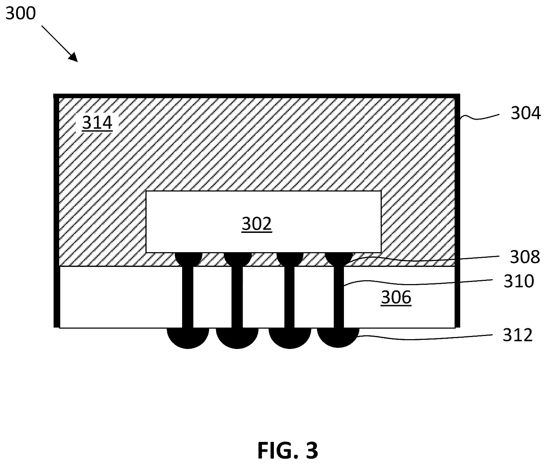

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

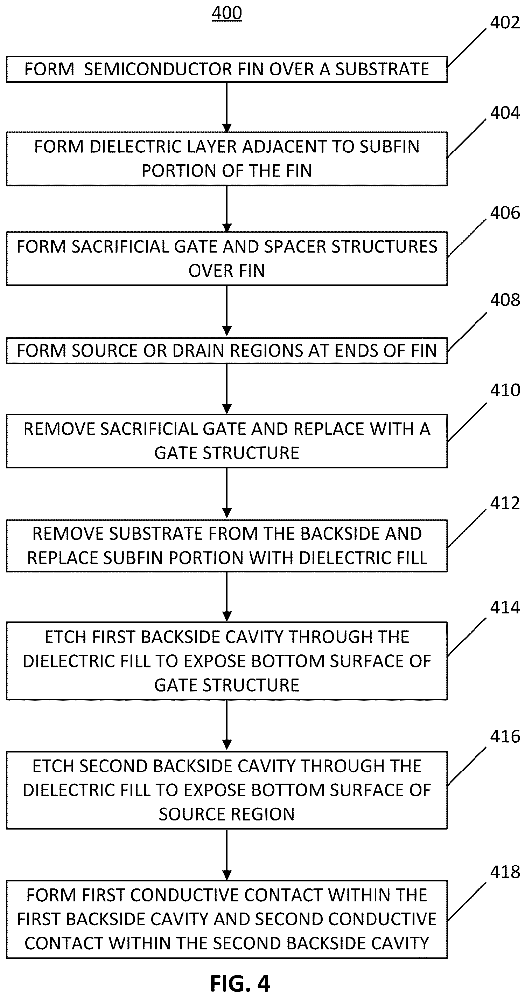

Figure 4 is a flow chart of a method 400 for forming at least a portion of an integrated circuit, according to an embodiment. Various operations of method 400 may be illustrated in Figures 2A - 2N. However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. For example, method 400 does not explicitly describe various standard processes that are usually performed to form transistor structures. Some of the operations of method 400 may be performed in a different order than the illustrated order.

Method 400 begins with operation 402 where a plurality of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

Method 400 continues with operation 404 where a dielectric layer is formed around subfin portions of at least one of the fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 400 continues with operation 406 where a sacrificial gate is formed over at least one of the fins. The sacrificial gate may be patterned using a gate masking layer in a strip that runs orthogonally over the at least one fin, Multiple gate masking layers may be formed that run parallel to one another (e.g., forming a cross-hatch pattern with the fins). The gate masking layer may be any suitable hard mask material, such as CHM or silicon nitride. The sacrificial gate may be formed from any suitable material that can be selectively removed at a later time without damaging the semiconductor material of the fin. In one example, the sacrificial gate includes polysilicon.

According to some embodiments, spacer structures are also formed on sidewalls of at least the sacrificial gate. The spacer structures may be deposited and then etched back such that the spacer structures remain mostly only on sidewalls of any exposed structures. In some cases, spacer structures may also be formed along sidewalls of the exposed fin running orthogonally between strips of sacrificial gates. According to some embodiments, the spacer structures may be any suitable dielectric material, such as silicon nitride or silicon oxynitride.

Method 400 continues with operation 408 where source or drain regions are formed at opposite ends of the fin. Any exposed portions of the fin not covered by the sacrificial gate or spacer structures may be removed using any anisotropic etching process, such as reactive ion etching (RIE). Once the exposed fin portions have been removed, the source or drain regions may be formed in the areas that had been previously occupied by the exposed fin portions between the spacer structures. According to some embodiments, the source or drain regions are epitaxially grown from the exposed semiconductor material of the fin (or nanoribbons, nanowires or nanosheets, as the case may be) along the exterior walls of the spacer structures. In some example embodiments, the source or drain regions are NMOS source or drain regions (e.g., epitaxial silicon) or PMOS source or drain regions (e.g., epitaxial SiGe). A dielectric fill may be formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth.

Method 400 continues with operation 410 where gate structures are formed over the semiconductor material of the semiconductor fin. The sacrificial gate is first removed along with any sacrificial layers within the exposed fin between the spacer structures (in the case of GAA structures). The gate structure may then be formed in place of the sacrificial gate. The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 400 continues with operation 412 where the substrate is removed from the backside of the structure to expose the bottom surface of the subfin portions and/or the bottom surface of the dielectric layer adjacent to the subfin portions. The substrate may be removed using any number of isotropic etching, polishing, or grinding operations. The subfin portions may also be removed and replaced with any suitable dielectric material(s), such as silicon dioxide. Any other dielectric materials may also be present on the backside of the structure to collectively form a base dielectric structure beneath the semiconductor devices.

Method 400 continues with operation 414 where a first backside cavity is formed through at least a portion of the base dielectric structure on the backside to expose the bottom surface of the gate structure. The backside cavity may be formed using an anisotropic etching technique, such as RIE. According to some embodiments, the backside cavity may have sidewalls that taper inwards towards the exposed bottom surface of the gate structure. In some examples, the backside cavity has a greatest width along the bottom surface of the base dielectric structure that is between about 15 nm and about 20 nm and a smallest width at the bottom surface of the gate structure that is between about 10 nm and about 15 nm.

Method 400 continues with operation 416 where a second backside cavity is formed through at least a portion of the base dielectric structure on the backside to expose the bottom surface of a source region adjacent to the gate structure. The second backside cavity may be formed using an anisotropic etching technique, such as RIE. According to some embodiments, the second backside cavity may have sidewalls that taper inwards towards the exposed bottom surface of the source region. In some examples, a same RIE process is used to simultaneously form both the first backside cavity and the second backside cavity.

Method 400 continues with operation 418 where a first backside contact is formed within the first backside cavity and a second backside contact is formed within the second backside cavity. According to some embodiments, the first backside contact is formed directly on exposed surface(s) of the gate structure (such as directly on the gate electrode), and the second backside contact is formed directly on exposed surface(s) of the source region. The first and second backside contacts may include any suitable conductive material, such as cobalt, ruthenium, molybdenum, or tungsten. According to some embodiments, a backside conductive trace is formed beneath and contacting both the first backside contact and the second backside contact. The first and second backside contacts may have a shortest distance between them of, for example, less than 8 nm or around 5 nm.

### Example System

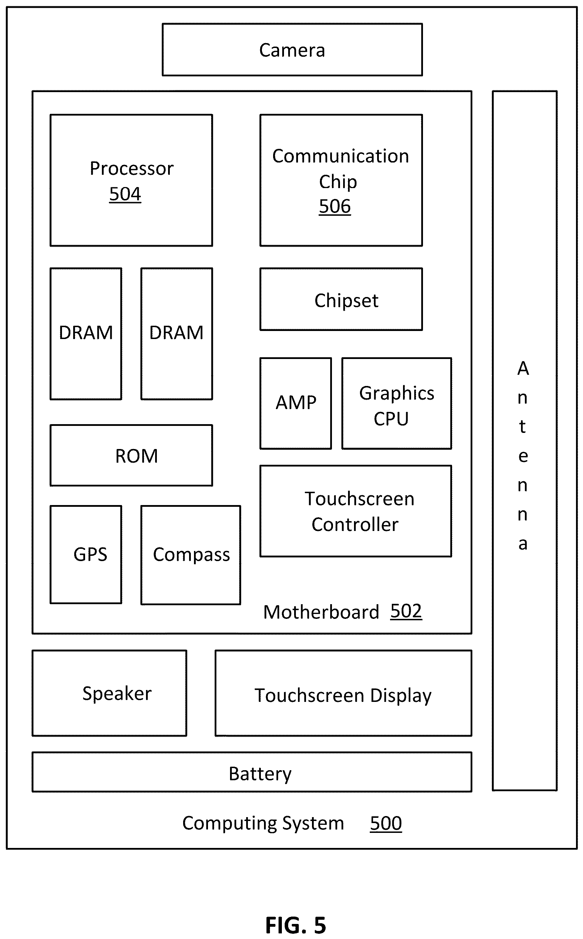

FIG. 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including one or more semiconductor devices that include one or more directly patterned and etched backside contacts as part of a gate tie-down structure, as variously provided herein). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a first source region to a second source or drain region and a gate structure extending in a second direction, different from the first direction, over the semiconductor region, a dielectric structure beneath the gate structure, the first source region, and the second source or drain region, a first backside conductive contact extending through the dielectric structure and contacting a bottom surface of the gate structure, a second backside conductive contact extending through the dielectric structure and contacting a bottom surface of the first source region, and a conductive layer beneath the dielectric structure. Both the first backside conductive contact and the second backside conductive contact directly contact the conductive layer.

Example 2 includes the integrated circuit of Example 1, further comprising a dielectric liner between the first backside conductive contact and the dielectric structure.

Example 3 includes the integrated circuit of Example 2, wherein the dielectric liner comprises silicon and nitrogen.

Example 4 includes the integrated circuit of Example 2, wherein the dielectric liner comprises aluminum and oxygen.

Example 5 includes the integrated circuit of any one of Examples 2-4, wherein at least a portion of the dielectric liner contacts at least a portion of the bottom surface of the gate structure.

Example 6 includes the integrated circuit of any one of Examples 1-5, wherein the first backside conductive contact has a tapered width along the first direction such that a first width of the first backside conductive contact at a bottom surface of the dielectric structure is greater than a second width of the first backside conductive contact at the bottom surface of the gate structure.

Example 7 includes the integrated circuit of Example 6, wherein the first width is at least 3 nm greater than the second width.

Example 8 includes the integrated circuit of any one of Examples 1-7, wherein the gate structure comprises a gate dielectric and a gate electrode on the gate dielectric.

Example 9 includes the integrated circuit of Example 8, wherein the first backside conductive contact extends through a thickness of the gate dielectric and directly contacts the gate electrode.

Example 10 includes the integrated circuit of Example 8 or 9, wherein the first backside conductive contact comprises a same conductive material as the gate electrode.

Example 11 includes the integrated circuit of any one of Examples 1-10, wherein the gate structure has a width along the first direction that is no greater than 30 nm.

Example 12 includes the integrated circuit of any one of Examples 1-11, wherein a distance along the first direction between the first backside conductive and the second backside conductive contact is less than 10 nm.

Example 13 includes the integrated circuit of any one of Examples 1-12, wherein the second source or drain region is a second source region, and the integrated circuit further comprises a third backside conductive contact extending through the dielectric structure and contacting a bottom surface of the second source region.

Example 14 includes the integrated circuit of any one of Examples 1-13, wherein the semiconductor region comprises a plurality of semiconductor nanoribbons.

Example 15 includes the integrated circuit of Example 14, wherein the plurality of semiconductor nanoribbons comprise germanium, silicon, or a combination thereof.

Example 16 is a die that includes the integrated circuit of any one of Examples 1-15.

Example 17 is an electronic device that includes a chip package having one or more dies. At least one of the one or more dies includes a semiconductor region extending in a first direction from a first source region to a second source or drain region, a gate structure extending in a second direction, different from the first direction, over the semiconductor region, a dielectric structure beneath the gate structure, the first source region, and the second source or drain region, a first backside conductive contact extending through the dielectric structure and contacting a bottom surface of the gate structure, and a second backside conductive contact extending through the dielectric structure and contacting a bottom surface of the first source region. The first backside conductive contact has a tapered width along the first direction such that a first width of the first backside conductive contact at a bottom surface of the dielectric structure is greater than a second width of the first backside conductive contact at the bottom surface of the gate structure.

Example 18 includes the electronic device of Example 17, wherein the at least one of the one or more dies further comprises a dielectric liner between the first backside conductive contact and the dielectric layer.

Example 19 includes the electronic device of Example 18, wherein the dielectric liner comprises silicon and nitrogen.

Example 20 includes the electronic device of Example 18, wherein the dielectric liner comprises aluminum and oxygen.

Example 21 includes the electronic device of any one of Examples 18-20, wherein at least a portion of the dielectric liner contacts at least a portion of the bottom surface of the gate structure.

Example 22 includes the electronic device of any one of Examples 17-21, wherein the at least one of the one or more dies further comprises a conductive layer beneath the dielectric layer, wherein both the first backside conductive contact and the second backside conductive contact directly contact the conductive layer.

Example 23 includes the electronic device of Example 22, wherein the at least one of the one or more dies further comprises a third backside conductive contact extending through the dielectric layer and contacting a bottom surface of the second source or drain region.

Example 24 includes the electronic device of any one of Examples 17-23, wherein the first width is at least 3 nm greater than the second width.

Example 25 includes the electronic device of any one of Examples 17-24, wherein the gate structure comprises a gate dielectric and a gate electrode on the gate dielectric.

Example 26 includes the electronic device of Example 25, wherein the first backside conductive contact extends through a thickness of the gate dielectric and directly contacts the gate electrode.

Example 27 includes the electronic device of Example 25 or 26, wherein the first backside conductive contact comprises a same conductive material as the gate electrode.

Example 28 includes the electronic device of any one of Examples 17-27, wherein the gate structure has a width along the first direction that is no greater than 30 nm.

Example 29 includes the electronic device of any one of Examples 17-28, wherein a distance along the first direction between the first backside conductive and the second backside conductive contact is less than 10 nm.

Example 30 includes the electronic device of any one of Examples 17-29, wherein the semiconductor region comprises a plurality of semiconductor nanoribbons.

Example 31 includes the electronic device of Example 30, wherein the plurality of semiconductor nanoribbons comprise germanium, silicon, or a combination thereof.

Example 32 includes the electronic device of any one of Examples 17-31, further comprising a printed circuit board, wherein the chip package is coupled to the printed circuit board.

Example 33 is a method of forming an integrated circuit. The method includes forming a fin comprising semiconductor material, the fin extending above a substrate; forming a dielectric layer adjacent to a subfin of the fin; forming a sacrificial gate and spacer structures over the fin; removing portions of the fin not covered by the sacrificial gate and spacer structures; forming source and drain regions at exposed ends of the semiconductor material and over the subfin; replacing the sacrificial gate with a gate structure; removing a portion of the substrate from a backside of the integrated circuit; removing the subfin from the backside and replacing the subfin with a dielectric fill; etching a first cavity through the dielectric fill such that a bottom surface of the gate structure is exposed within the first cavity; etching a second cavity through the dielectric fill such that a bottom surface of the source region is exposed within the second cavity, the second cavity being adjacent to the first cavity; and forming a first conductive contact in the first cavity and a second conductive contact in the second cavity.

Example 34 includes the method of Example 33, wherein etching the first cavity comprises etching the first cavity using reactive ion etching (RIE), and etching the second cavity comprises etching the second cavity using RIE.

Example 35 includes the method of Example 33 or 34, wherein the dielectric fill comprises the same material composition as the dielectric layer.

Example 36 includes the method of any one of Examples 33-35, wherein the gate structure comprises a gate dielectric and a gate electrode on the gate dielectric. The method further includes forming a dielectric liner in the first cavity; removing a portion of the dielectric liner on the bottom surface of the gate structure; and etching through the gate dielectric within the first cavity to expose the gate electrode.

Example 37 includes the method of Example 36, wherein forming the first conductive contact comprises forming the first conductive contact on the dielectric liner and directly on the gate electrode.

Example 38 is an integrated circuit that includes a semiconductor device having a semiconductor region extending in a first direction from a first source region to a second source or drain region and a gate structure extending in a second direction, different from the first direction, over the semiconductor region, a dielectric structure beneath the gate structure, the first source region, and the second source or drain region, a first backside conductive contact extending through the dielectric structure and contacting a bottom surface of the gate structure, and a second backside conductive contact extending through the dielectric structure and contacting a bottom surface of the first source region. A distance along the first direction between the first backside conductive contact and the second backside conductive contact is less than 10 nm.

Example 39 includes the integrated circuit of Example 38, further comprising a dielectric liner between the first backside conductive contact and the dielectric structure.

Example 40 includes the integrated circuit of Example 39, wherein the dielectric liner comprises silicon and nitrogen.

Example 41 includes the integrated circuit of Example 39, wherein the dielectric liner comprises aluminum and oxygen.

Example 42 includes the integrated circuit of any one of Examples 39-41, wherein at least a portion of the dielectric liner contacts at least a portion of the bottom surface of the gate structure.

Example 43 includes the integrated circuit of any one of Examples 38-42, wherein the first backside conductive contact has a tapered width along the first direction such that a first width of the first backside conductive contact at a bottom surface of the dielectric structure is greater than a second width of the first backside conductive contact at the bottom surface of the gate structure.

Example 44 includes the integrated circuit of Example 43, wherein the first width is at least 3 nm greater than the second width.

Example 45 includes the integrated circuit of any one of Examples 38-44, wherein the gate structure comprises a gate dielectric and a gate electrode on the gate dielectric.

Example 46 includes the integrated circuit of Example 45, wherein the first backside conductive contact extends through a thickness of the gate dielectric and directly contacts the gate electrode.

Example 47 includes the integrated circuit of Example 45 or 46, wherein the first backside conductive contact comprises a same conductive material as the gate electrode.

Example 48 includes the integrated circuit of any one of Examples 38-47, wherein the gate structure has a width along the first direction that is no greater than 30 nm.

Example 49 includes the integrated circuit of any one of Examples 38-48, further comprising a conductive layer beneath the dielectric structure, wherein both the first backside conductive contact and the second backside conductive contact directly contact the conductive layer.

Example 50 includes the integrated circuit of any one of Examples 38-49, further comprising a third backside conductive contact extending through the dielectric structure and contacting a bottom surface of the second source or drain region.

Example 51 includes the integrated circuit of any one of Examples 38-50, wherein the semiconductor region comprises a plurality of semiconductor nanoribbons.

Example 52 includes the integrated circuit of Example 51, wherein the plurality of semiconductor nanoribbons comprise germanium, silicon, or a combination thereof.

Example 53 is a die that includes the integrated circuit of any one of Examples 38-52.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor device having a semiconductor region extending in a first direction from a first source region to a second source or drain region, and a gate structure extending in a second direction, different from the first direction, over the semiconductor region;
a dielectric structure beneath the gate structure, the first source region, and the second source or drain region;
a first backside conductive contact extending through the dielectric structure and contacting a bottom surface of the gate structure;
a second backside conductive contact extending through the dielectric structure and contacting a bottom surface of the first source region; and
a conductive layer beneath the dielectric structure, wherein both the first backside conductive contact and the second backside conductive contact directly contact the conductive layer.

2. The integrated circuit of claim 1, further comprising a dielectric liner between the first backside conductive contact and the dielectric structure.

3. The integrated circuit of claim 2, wherein the dielectric liner comprises silicon and nitrogen.

4. The integrated circuit of claim 2, wherein the dielectric liner comprises aluminum and oxygen.

5. The integrated circuit of any one of claims 2-4, wherein at least a portion of the dielectric liner contacts at least a portion of the bottom surface of the gate structure.

6. The integrated circuit of any one of claims 1-5, wherein the first backside conductive contact has a tapered width along the first direction such that a first width of the first backside conductive contact at a bottom surface of the dielectric structure is greater than a second width of the first backside conductive contact at the bottom surface of the gate structure.

7. The integrated circuit of claim 6, wherein the first width is at least 3 nm greater than the second width.

8. The integrated circuit of any one of claims 1-7, wherein the gate structure comprises a gate dielectric and a gate electrode on the gate dielectric, and wherein the first backside conductive contact extends through a thickness of the gate dielectric and directly contacts the gate electrode.

9. The integrated circuit of claim 8, wherein the first backside conductive contact comprises a same conductive material as the gate electrode.

10. The integrated circuit of any one of claims 1-9, wherein the gate structure has a width along the first direction that is no greater than 30 nm.

11. The integrated circuit of any one of claims 1-10, wherein a distance along the first direction between the first backside conductive and the second backside conductive contact is less than 10 nm.

12. The integrated circuit of any one of claims 1-11, wherein the second source or drain region is a second source region, and the integrated circuit further comprises a third backside conductive contact extending through the dielectric structure and contacting a bottom surface of the second source region.

13. The integrated circuit of any one of claims 1-12, wherein the semiconductor region comprises a plurality of semiconductor nanoribbons.

14. A die comprising the integrated circuit of any one of claims 1-13.

15. A method of forming an integrated circuit, the method comprising:
forming a fin comprising semiconductor material, the fin extending above a substrate;
forming a dielectric layer adjacent to a subfin of the fin;
forming a sacrificial gate and spacer structures over the fin;
removing portions of the fin not covered by the sacrificial gate and spacer structures;
forming source and drain regions at exposed ends of the semiconductor material and over the subfin;
replacing the sacrificial gate with a gate structure;
removing a portion of the substrate from a backside of the integrated circuit;
removing the subfin from the backside and replacing the subfin with a dielectric fill;
etching a first cavity through the dielectric fill such that a bottom surface of the gate structure is exposed within the first cavity;
etching a second cavity through the dielectric fill such that a bottom surface of the source region is exposed within the second cavity, the second cavity being adjacent to the first cavity; and
forming a first conductive contact in the first cavity and a second conductive contact in the second cavity.
